Europäisches Patentamt

European Patent Office

Office européen des brevets

(11) Veröffentlichungsnummer: **0 315 145**
**A1**

## (12) EUROPÄISCHE PATENTANMELDUNG

(21) Anmeldenummer: 88118250.5

(22) Anmeldetag: 02.11.88

(51) Int. Cl.⁴: **H01L 29/08 , H01L 21/322 , H01L 29/32 , H01L 29/72 , H01L 29/74**

(30) Priorität: 03.11.87 DE 3737288

(43) Veröffentlichungstag der Anmeldung:
10.05.89 Patentblatt 89/19

(84) Benannte Vertragsstaaten:
CH DE FR GB IT LI SE

(71) Anmelder: **Siemens Aktiengesellschaft Berlin und München**
**Wittelsbacherplatz 2**
**D-8000 München 2(DE)**

(72) Erfinder: **Miller, Gerhard, Dr.-Ing.**
**Steinacker 3**
**D-8916 Penzing(DE)**
Erfinder: **Tihanyi, Jenö, Dr.-Ing.**
**Windeckstrasse 1 d**
**D-8000 München 70(DE)**
Erfinder: **Wehr, Peter**
**Adamstrasse 7**
**D-8000 München 19(DE)**

(54) **Leistungs-Halbleiterbauelement mit vier Schichten.**

(57) Halbleiterbauelemente mit vier Zonen abwechselnden Leitungstyps haben eine Sperrverzögerungsladung, die sich beim Abschalten als sogenannter "Tail"-Strom bemerkbar macht. Der Tail-Strom läßt sich dadurch reduzieren, daß die anodenseitige Emitterzone (4) durch Laserbeschuß erzeugte gestörte Bereiche (10) enthält, die durch den pn-Übergang (5) bis in die Mittelzone (1) reichen.

FIG 2

EP 0 315 145 A1

Leistungs-Halbleiterbauelement mit vier Schichten

Die Erfindung bezieht sich auf ein Leistungs-Halbleiterbauelement mit mindestens einer katodenseitigen Emitterzone, mindestens einer katodenseitigen Basiszone, einer Mittelzone und mindestens einer anodenseitigen Emitterzone.

Leistungs-Halbleiterbauelemente dieser Art sind allgemein bekannt. Im Inneren des Halbleiterbauelements wird der Strom durch beide Ladungsträgerarten transportiert, wodurch sich eine Trägerspeicherladung aufbaut, die sich beim Abschalten als sogenannter "Tail"-Strom bemerkbar macht. Solange dieser Strom fließt, sperrt das Bauelement nicht vollständig. Da während der Zeit, in der der Tail-Strom fließt, die Spannung bereits angestiegen ist, wird im Bauelement eine relativ hohe Verlustarbeit in Wärme umgewandelt.

Ziel der Erfindung ist eine Verkürzung der Tail-Stromdauer und eine Verringerung der Verlustarbeit.

Dieses Ziel wird dadurch erreicht, daß die anodenseitige Emitterzone durch Lasereinschüsse gestörte Bereiche enthält und daß sich diese Bereiche durch den zwischen anodenseitiger Emitterzone und Mittelzone liegenden pn-Übergang hindurch bis in die Mittelzone erstrecken.

Weiterbildungen der Erfindung sind Gegenstand der Unteransprüche.

Die Erfindung wird anhand zweier Ausführungsbeispiele in Verbindung mit den FIG 1 bis 7 näher erläutert. Es zeigen:

FIG 1 ein Strom-Zeitdiagramm für den Abschaltstrom eines herkömmlichen Leistungs-Halbleiterbauelements mit vier Zonen,

FIG 2 den Schnitt durch ein erstes Ausführungsbeispiel

FIG 3 den Schnitt durch ein zweites Ausführungsbeispiel

FIG 4 das Strom-Zeitdiagramm für den Abschaltstrom eines Leistungs-Halbleiterbauelements nach der Erfindung und

FIG 5 bis 7 drei verschiedene Ausführungsbeispiele für die Anordnung und Gestalt der gestörten Zonen.

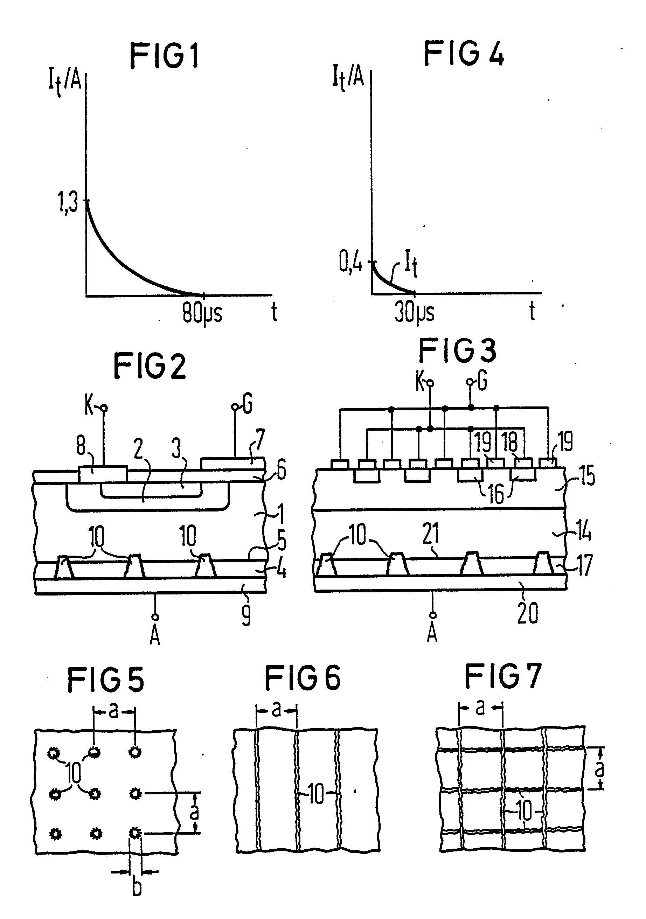

Das Strom-Zeitdiagramm der FIG 1 zeigt den Tailstrom $I_t$ für einen bekannten Bipolartransistor mit isolierter Gateelektrode (IGBT) für ohmsche Belastung. Dieser Strom hat seine Ursache in den im Halbleiterkörper ablaufenden Rekombinationen. Er dauert 80μs.

In FIG 2 ist der Halbleiterkörper eines solchen IGBT dargestellt. Dies ist ein Bipolar-Transistor mit vier Zonen abwechselnden Leitungstyps, der durch ein isoliertes Gate gesteuert wird. Die Mittelzone ist mit 1 bezeichnet. Sie ist n-dotiert und hat eine erste, gegebene Dotierungskonzentration. In die Mittelzone 1 ist eine p-dotierte katodenseitige Basiszone 2 von höherer Dotierungskonzentration als die Mittelzone 1 eingebettet. In die Zone 2 wiederum ist eine katodenseitige n-dotierte Emitterzone 3 eingebettet. Sie hat höhere Dotierungskonzentration als die Zone 2. Anodenseitig ist der Halbleiterkörper mit einer p-dotierten Emitterzone 4 versehen, die höher dotiert ist als die Zone 1. Die katodenseitige Oberfläche des Halbleiterkörpers ist mit einer Isolierschicht 6 versehen, auf der eine Gateelektrode 7 angeordnet ist. Diese überdeckt die Basiszone teilweise dort, wo sie an die Oberfläche des Halbleiterkörpers tritt. Auf der von der Gateelektrode abgewandten Seite der Zonen 2, 3 ist eine Katodenelektrode 8 angeordnet, die einen starken Nebenschluß zwischen den Zonen 2 und 3 bildet. Dieser Nebenschluß verhindert das vom Thyristor bekannte Einrasten. Die anodenseitige Emitterzone 4 ist mit einer Anodenelektrode 9 kontaktiert.

Die anodenseitige Emitterzone 4 ist mit gestörten Bereichen 10 versehen, die durch die anodenseitige Emitterzone 4 hindurchgehen, den zwischen den Zonen 1 und 4 liegenden pn-Übergang 5 durchdringen und bis in die Mittelzone 1 hineinreichen. Die gestörten Bereiche werden durch Lasereinschüsse hergestellt. Hierzu kann jeder geeignete Laser verwendet werden. Die Technik der Bearbeitung von Halbleiterbauelementen mit Lasern ist z. B. aus der Zeitschrift "Journal of the Electrochemical Society" Band 126, (1979) No. 8, S. 1436 + 1437 bekannt. Die gestörten Bereiche 10 werden durch Aufschmelzen mittels der Laserenergie erzeugt. Die Energie ist derart eingestellt, daß der Halbleiterkörper bis in eine Tiefe aufschmilzt, die größer ist als diejenige Tiefe, in der der pn-Übergang 5 liegt. Die anodenseitige Emitterzone kann z. B. zwischen 5 und 10 μm dick sein, die Tiefe der Bereiche 10 kann z. B. 2μm größer sein. Die Dicke der Zone 4 kann aber auch geringer sein und in der Größenordnung 1μm liegen.

Mit den gestörten Bereichen 10 wird der Emitterwirkungsgrad des aus den Zonen 2, 1 und 4 bestehenden Bipolar-Transistors herabgesetzt, da dort keine oder nur eine reduzierte Emission von Ladungsträgern stattfindet. Die Bereiche stellen außerdem Zentren erhöhter Rekombination dar, so daß die Ladungsträgerkonzentration in der Mittelzone 1 abgesenkt werden kann. Am stärksten wird sie in der Nähe des pn-Übergangs 5 abgesenkt.

In FIG 3 ist ein Abschaltthyristor dargestellt, der auch als GTO-Thyristor bekannt ist. Er hat eine n-dotierte Mittelzone 14, eine katodenseitige Basiszone 15, in die katodenseitige Emitterzonen 16 eingebettet sind. Er hat außerdem eine anodenseitige Emitterzone 17, die mit einer Andodenelektrode 20 kontaktiert ist. Die Dotierungsverhältnisse entsprechen denen des Halbleiterkörpers nach FIG 2. Die Emitterzonen sind mit Emitterelektroden 18 versehen, zwischen denen Gateelektroden 19 angeordnet und mit der Zone 15 elektrisch verbunden sind. Die Gateelektroden 19 und die Emitterelektroden 18 sind jeweils elektrisch parallelgeschaltet. Anodenseitig sind wie beim IGBT nach FIG 2 gestörte Zonen 10 vorgesehen, die den pn-Übergang 21 zwischen den Zonen 14 und 17 durchdringen.

Das Strom-Zeitdiagramm nach FIG 4 zeigt deutlich die Verbesserung des Ausschaltverhaltens. Der Tail-Strom $I_t$ setzt erst bei einem verglichen mit dem Verlauf nach FIG 1 niedrigeren Stromwert von 0,4 A ein und hört bereits nach 30μs zu fließen auf. Die im Halbleiterkörper umgesetzte Verlustarbeit wurde hierbei gegenüber dem Verlauf nach FIG 1 auf etwa 20 % reduziert. Dies wurde an einem IGBT gemessen, dessen Halbleiterkörper eine Dicke von etwa 500 μm hatte. Die p-dotierten Zonen 2 und 4 hatten eine Dicke von etwa 4 μm und waren durch Ionenimplantation mit einer Dosis von 1x $10^{15}$ cm$^{-2}$ und einer Energie von 45 keV hergestellt worden. Die gestörten Bereiche waren, wie in FIG 5 dargestellt, inselförmig ausgebildet und gleichmäßig über die anodenseitige Emitterzone 4 verteilt. Ihr Durchmesser und ihre Tiefe betrug etwa 10 μm. Der Abstand lag bei 100 μm. Die gestörten Bereiche 10 nehmen damit etwa 1 % der Fläche der Zone 4 ein. Je nach den Erfordernissen ist es auch möglich, diese Fläche z. B. zwischen 0, 5 und 10 % zu variieren.

Die gestörten Bereiche können, wie in FIG 6 dargestellt, auch streifenförmig ausgebildet sein. Die Streifen liegen dabei einander parallel. Es ist auch möglich, die gestörten Bereiche 10 als Gitter sich kreuzender streifenförmiger Bereiche anzuordnen. Auch in FIG 6 und 7 kann der Flächenanteil der gestörten Bereiche an der Fläche der Zone 4 zwischen 0,5 und 10, vorzugsweise bei 1 % liegen.

Die Ausführungsbeispiele beziehen sich auf Halbleiterbauelemente, deren katodenseitige Emitterzone eine dotierte Halbleiterzone ist. Sie kann jedoch auch aus einer Metall-Siliziumverbindung bestehen, z. B. aus Platinsilizid.

## Ansprüche

1. Leistungs-Halbleiterbauelement mit mindestens einer katodenseitigen Emitterzone (3,16), mindestens einer katodenseitigen Basiszone (2,15) einer Mittelzone (1,14) und mindestens einer anodenseitigen Emitterzone (4,17),
**dadurch gekennzeichnet,** daß die anodenseitige Emitterzone (4,17) durch Lasereinschüsse gestörte Bereiche (10) enthält, und daß sich diese Bereiche durch den zwischen anodenseitiger Emitterzone (4,17) und Mittelzone (1,14) liegenden pn-Übergang (5,21) hindurch bis in die Mittelzone erstrecken.

2. Leistungs-Halbleiterbauelement nach Anspruch 1,
**dadurch gekennzeichnet,** daß die gestörten Bereiche eine Fläche von 0,5 bis 10 % der Fläche der anodenseitigen Emitterzone einnehmen.

3. Leistungs-Halbleiterbauelement nach Anspruch 1 oder 2,
**dadurch gekennzeichnet,** daß die gestörten Bereiche inselförmig ausgebildet und über die anodenseitige Emitterzone gleichmäßig verteilt sind.

4. Leistungs-Halbleiterbauelement nach Anspruch 1 oder 2,
**dadurch gekennzeichnet,** daß die gestörten Bereiche streifenförmig ausgebildete und parallel zueinander angeordnet sind.

5. Leistungs-Halbleiterbauelement nach Anspruch 1 oder 2,
**dadurch gekennzeichnet,** daß die gestörten Bereiche streifenförmig ausgebildet sind und ein Gitter bilden.

EP 0 315 145 A1

FIG 1

FIG 4

FIG 2

FIG 3

FIG 5

FIG 6

FIG 7

**Europäisches Patentamt**

**EUROPÄISCHER RECHERCHENBERICHT**

Nummer der Anmeldung

EP 88 11 8250

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| A | GB-A-1 124 176 (LICENTIA PATENT-VERWALTUNGS-GmbH) * Seite 1, Zeile 57 - Seite 2, Zeile 34; Figur * --- | 1-5 | H 01 L 29/08 H 01 L 21/322 H 01 L 29/32 H 01 L 29/72 H 01 L 29/74 |
| A | PATENT ABSTRACTS OF JAPAN, Band 4, nr. 165 (E-34)[647], 15. November 1980, Seite 155 E 34; & JP-A-55 115 364 (NIPPON DENKI K.K.) 05-09-1980 * Zusammenfassung; Figur * --- | 1 | |
| A | IEEE TRANSACTIONS ON ELECTRON DEVICES, Band ED-17, Nr. 9, September 1970, Seiten 667-672, IEEE, New York, US; R.A. KOKOSA et al.: "A high-voltage, high-temperature reverse conducting thyristor" * Seite 669, Spalte 2, Zeilen 26-27; Figur 3 * --- | 1,3 | |
| D,A | JOURNAL OF THE ELECTROCHEMICAL SOCIETY, Band 126, Nr. 8, August 1979, Seiten 1436-1437, Princeton, New Jersey, US; C.W. PEARCE et al.: "An new approach to lattice damage gettering" ----- | | **RECHERCHIERTE SACHGEBIETE (Int. Cl.4)** H 01 L |

Der vorliegende Recherchenbericht wurde für alle Patentansprüche erstellt

| Recherchenort | Abschlußdatum der Recherche | Prüfer |
|---|---|---|
| DEN HAAG | 08-02-1989 | MORVAN D.L.D. |